# EUROPÄISCHE PATENTSCHRIFT

(11) **EP 0 941 576 B1**
(45) Veröffentlichungstag und Bekanntmachung des Hinweises auf die Patenterteilung: **30.05.2001**
(21) Anmeldenummer: 97951202.7
(22) Anmeldetag: 14.11.1997
(51) Int. Cl.: H03H 9/05, H03H 9/10

(54) **RESONATOR MIT KRISTALL**
CRYSTAL RESONATOR
RESONATEUR A CRISTAL

(30) Priorität: 28.11.1996 DE 19649332
(43) Veröffentlichungstag der Anmeldung: 15.09.1999
(73) Patentinhaber: Tele Quarz GmbH, 74924 Neckarbischofsheim (DE)
(72) Erfinder: PFEIL, Gerhard, D-74889 Sinsheim (DE)
(74) Vertreter: Weber, Walter, Dipl.-Ing.(FH)
(86) Internationale Anmeldenummer: EP9706363
(87) Internationale Veröffentlichungsnummer: WO9824178

(56) Entgegenhaltungen:
- WO-A-84/00082
- GB-A- 2 055 232
- GB-A- 2 282 260
- US-A- 4 421 621
- US-A- 5 394 123
- 36th Annual Freq. Control Symp. 1982; C.W. Shanley et al: DC plasma anodization of quartz resonators XP002060294

## Beschreibung

Die Erfindung betrifft einen Resonator mit mindestens einem Kristall, mindestens zwei diesen Kristall anregenden Elektroden und einem in Sandwich-Bauweise aufgebauten Gehäuse mit einem im wesentlichen scheibenförmigen Boden, mindestens einem rahmenförmigen Mittelteil, das den Kristall umgibt und in schwingfähiger Weise trägt, und einem im wesentlichen scheibenförmigen Deckel, wobei diese Gehäuseteile unter Einschluß von leitenden Schichten durch Dichtflächen miteinander verbunden sind und die Elektroden jeweils mit einer leitenden Schicht elektrisch in Verbindung stehen. Die Erfindung betrifft weiterhin ein Verfahren zur Herstellung eines derartigen Resonators.

Die Erfindung betrifft weiterhin ein Verfahren zur Herstellung eines Resonators (1, 1') mit mindestens einem Mittelteil (7, 7') aus einer Kristallscheibe mit zwei Elektroden (3, 3', 4, 4') sowie einem Boden (6) und einem Deckel (8) durch folgende Verfahrensschritte:
a) die aktive Kristallfläche (2, 2') wird derart freigestellt, daß mindestens ein Verbindungssteg (28, 29, 30) zum dadurch entstehenden rahmenförmigen Mittelteil (7, 7') erhalten bleibt,
b) die aktive Kristallfläche (2, 2') wird derart bearbeitet, daß die gewünschte mechanische Abmessung erzielt ist,
c) die Elektroden (3, 3') werden aufgebracht und gegebenenfalls zum Abgleich bearbeitet sowie mit den leitenden Schichten (9, 10, 11, 12) verbunden, das mindestens eine Mittelteil (7, 7'), der Boden (6) und der Deckel (8) werden zusammengefügt.

Bei den heute üblichen Resonatoren handelt es sich um piezoelektrische Kristallelemente, die in hermetisch dichte Gehäuse, vorwiegend aus Glas, Metall oder Keramik, montiert sind. Das Kristallelement wird in solche Gehäuse mit einem Leitkleber montiert, der die elektrische Verbindung von den meist aufgedampften Elektroden mit den elektrischen Durchführungen oder Durchkontaktierungen des Gehäuses verbindet und gleichzeitig die mechanische Verbindung des Kristallelements mit dem Gehäuse darstellt. Resonatoren mit derartigen Gehäusen sind relativ große Bauelemente, die aufwendig herzustellen sind, da Vertiefungen oder Freiräume benötigt werden, die wegen der mechanischen Toleranzen und der Verwendung von Leitklebern genügend groß sein müssen.

Aus diesem Grund schlägt die US 4,293,986 vor, einen Resonator in der eingangs genannten Art auszubilden. Dabei wird eine rahmenförmige Quarzscheibe, die die aktive Kristallfläche umgibt, mit einem Boden und einem Deckel zu einem sandwichförmigen Gehäuse zusammengefügt. Diese Bauteile schließen leitende Flächen ein, wobei sich die aktive Kristallfläche in einem Freiraum befindet, der durch wannenförmige Ausnehmungen von Boden und Deckel gebildet wird. Auf diese Weise wird zwar eine Verkleinerung des Bauelements erreicht, dieses Bauelement läßt sich jedoch nur in aufwendiger Weise auf eine Leiterplatte montieren. Ein direktes Auflöten unter Herstellung der erforderlichen Anschlüsse ist nicht möglich, es sei denn, man würde das Bauelement mit der Schmalseite auflöten, was aus Stabilitätsgründen, insbesondere wegen der schlechten Schockeigenschaften, nicht in Frage kommt. Aus diesem Grund sind Hilfskonstruktionen für die Herstellung der Anschlüsse, wie zum Beispiel Drähte, erforderlich. Ein derartiges Bauteil läßt sich nicht in SMD-Technik (Surface Mounted Devices) auf eine Leiterplatte bringen.

Ein Resonator der oben genannten Art ist auch aus der US 4, 421, 621 bekannt. Dieser enthält einen gabelförmigen Schwingquarz, wobei leitende Schichten teilweise durch senkrechte leitende Flächen, meistens mittels Durchbrechung miteinander verbunden sind. Es erfolgt jedoch keine Verbindung der Potentiale zum scheibenförmigen Boden, damit das Bauteil mittels SMD-Technik auf einer Leitrerplatte angebracht und dabei angeschlossen werden kann.

Der Erfindung liegt daher die Aufgabe zugrunde, einen Resonator der eingangs genannten Art derart weiterzubilden, daß er in SMD-Technik weiterverarbeitet werden kann.

Die Aufgabe wird erfindungsgemäß dadurch gelöst, daß sich an mindestens einer Seite des Gehäuses insgesamt mindestens zwei leitende Flächen derart zum Fuß des Bodens erstrecken, daß dieser damit auf eine Leiterplatte auflötbar ist, wobei die leitenden Schichten jeweils außerhalb der Dichtflächen zur Potentialtrennung unterbrochen sind.

Die Aufgabe wird weiterhin durch ein Verfahren der oben genannten Art gelöst, bei dem vor dem Zusammenfügen mindestens eine Kristallscheibe beidseitig mit leitenden Schichten versehen wird, wobei die aktive Kristallfläche und mindestens eine Unterbrechung außerhalb von Dichtflächen, die der Erzielung eines abgedichteten Gehäusebereichs dienen, ausgespart bleiben, und zumindest der Boden mit mindestens zwei leitenden Flächen versehen wird, die sich derart zum Fuß des Bodens erstrecken, daß dieser damit auf eine Leiterplatte auflötbar ist und elektrische Verbindungen zu den leitenden Schichten der mindestens einen Kristallscheibe herstellbar sind.

Durch die Erfindung wird ein hermetisch dichtes, preiswertes SMD-Bauelement mit geringem Volumen verfügbar gemacht. Dieses Bauelement ist mit dem Auflöten auf die Leiterplatte fertig angeschlossenes sind keine Verdrahtungen, Bohrungen oder Durchkontaktierungen erforderlich. Die leitenden Schichten dienen als Durchkontaktierungen und vorzugsweise gleichzeitig als Dichtflächen, wobei die Potentialtrennungen außerhalb der Dichtflächen dazu dienen, mehrere Anschlüsse an den Rand des sandwichartigen Gehäuses zu führen, um sie von dort mit auf eine Leiterplatte auflötbaren Anschlüssen des Bodens zu verbinden. Auf diese Weise entsteht ein SMD-Bauelement, das mit einer Vielzahl verschiedener Potentiale verbindbar ist. Das Prinzip besteht also darin, daß jeder leitenden Schicht, die zwischen den Gehäuseteilen liegt, ein Potential zugeordnet ist. Da diese Schichten elektrisch voneinander getrennt sind, können sie der Verbindung der Elektroden mit jeweils einer Leiterbahn der Leiterplatte dienen. Das Bauelement ist einfach herstellbar und bietet, wie die verschiedenen Ausführungsformen und Weiterbildungen zeigen, eine große Zahl von Ausgestaltungsmöglichkeiten.

Der Resonator läßt sich beispielsweise derart ausbilden, daß sich die leitenden Schichten auf dem mindestens einen rahmenförmigen Mittelteil befinden, wobei diese mit Boden und Deckel zur Herstellung der Dichtflächen verbunden werden. Diese Dichtflächen, wie auch die der folgenden Ausführungsformen, sind durch verschiedene Verfahren herstellbar. Sie können aufgedampft werden oder durch Siebdruck, chemische Verfahren oder auch Kombinationen verschiedener Verfahren aufgebracht werden. Boden und Deckel können auf das rahmenförmige Mittelteil aufgeklebt oder in anderer Weise mit diesem verbunden werden.

Besonders zweckmäßig ist es, den Deckel durch Bonden (auch als anodisches Bonden oder Diffusionsbonden bekannt) mit dem Mittelteil zu verbinden. Selbstverständlich kann auch der Boden durch Bonden mit dem Mittelteil verbunden werden. Der Vorteil besteht darin, daß für den Deckel und/oder Boden keine metallischen Schichten erforderlich sind; sie können direkt mit der metallischen Schicht des Mittelteils verbunden werden. Auf diese Weise wird die Herstellung vereinfacht und eine haltbare Verbindung erzielt. Beispielsweise kann der Deckel nur aus einer Glasscheibe bestehen, die direkt mit einer Aluminiumschicht des Mittelteils, das den Kristall trägt, verbunden wird. Dasselbe gilbt für den Boden, der dann nur mit den seitlichen leitenden Schichten für den Anschluß auf der Leiterplatte ausgestattet sein muß.

Eine weitere Ausführungsform sieht vor, daß der Boden oben eine leitende Schicht aufweist, die mit der entsprechenden leitenden Schicht des Mittelteils verbunden ist, wobei diese mindestens im Bereich der Dichtfläche korrespondieren. Genauso ist es möglich, daß der Deckel unten eine leitende Schicht aufweist, die mit der entsprechenden Schicht des Mittelteils verbunden ist, wobei auch diese mindestens im Bereich der Dichtfläche korrespondieren. Da das Aufbringen von Metallschichten, beispielsweise auf Quarz, Glas oder Keramik, eine sehr stabile Verbindung ergibt, hat diese Ausführungsform den Vorteil, daß die Gehäuseelemente verlötet oder verschweißt werden können. Zweckmäßigerweise wird für die leitenden Schichten ein Metall mit einer Schmelztemperatur zwischen 240 und 600 °C vorgesehen. Dadurch ist eine einfache Verschweißung durch Reibschweißen oder Laserschweißen möglich, ohne daß die einzelnen Bestandteile in Mitleidenschaft gezogen werden. Es ist auch möglich, daß das Gehäuse unter Vakuum durch Unterdruck verschlossen wird, oder es sind Kombinationen denkbar, wie beispielsweise, daß der Deckel und der Boden zusammen mit dem Quarz unter Vakuum zusammengefügt und anschließend die Metallflächen verlötet oder verschweißt werden. Es ist auch möglich, daß die Metallschichten im Durchlaufofen miteinander verschmolzen werden, oder es kann eine Lötung derart erfolgen, daß ein Stempel, der von oben und unten während des Lötvorgangs die Teile zusammenhält, gleichzeitig zur Wärmeabfuhr und Abdichtung nach innen dient. Weitere Arten der Zusammenfügung und Verbindung der Gehäuseteile oder Kombinationen davon sind vorstellbar.

Eine zweckmäßige Ausführungsform sieht vor, daß die leitenden Schichten außerhalb der Dichtflächen weitere Unterbrechungen aufweisen. Diese Unterbrechungen können dazu dienen, daß nur so viele leitende Schichten aufeinanderliegen, wie für die Kontaktgabe und Abdichtung erforderlich sind. Der Grund besteht darin, daß die Metallschichten wie Spulen oder Kondensatoren wirken, die sich in Anbetracht oft erforderlicher niedriger Werte störend auswirken können. Solche weiteren Unterbrechungen können jedoch auch dazu dienen, weitere Bauelemente einzufügen, wie beispielsweise Leiterbahnen, Kondensatoren, Spulen usw. Solche Bauelemente können z.B. mittels Sputtertechnik aufgedampft werden. Auf diese Weise kann der Resonator zu einem integrierten Bauteil erweitert werden.

Besonders vorteilhaft ist es, wenn der Kristall und das rahmenförmige Mittelteil als einstückiges Bauteil ausgebildet sind, wobei die aktive Resonatorfläche des Kristalls unter Verbleib von mindestens einem Verbindungssteg freigestellt ist. Es kann sich ein Verbindungssteg, oder es können sich zwei Verbindungsstege an einer Seite der aktiven Resonatorfläche befinden, so daß sich eine Freistellung von ca. 350 Grad ergibt. Es ist jedoch auch möglich, zwei Verbindungsstege an gegenüberliegenden Seiten der aktiven Resonatorfläche anzubinden, womit sich eine Freistellung von ca. 2 mal 175 Grad ergibt. Die einzelnen Ausgestaltungen richten sich nach den Endeigenschaften des gewünschten Resonators. Die Freistellung kann entweder mechanisch, beispielsweise durch Bohren, oder durch einen Ätzprozeß erfolgen, bei dem vorher die nicht freizuätzenden Flächen mit Lack abgedeckt werden. Die Ausführungsform als einstückiges Bauteil hat den Vorteil, daß keine Verbindung des rahmenförmigen Mittelteils mit dem Kristall durch einen fremden Werkstoff, beispielsweise Klebstoff, erforderlich ist. Dies ist von Vorteil, da solche Werkstoffe, insbesondere Klebstoffe, die Alterungsbeständigkeit negativ beeinflussen. Durch zwei Verbindungsstege, welche mindestens je eine Elektrodenzuleitung tragen, können nachteilige Scherschwingungen vermieden werden.

Die aktive Kristallfläche kann zur Erzielung einer Dickenänderung bearbeitet sein. Gerade dadurch, daß der Schwingkörper an einem dicken Rand fest angebunden ist, kann er dünner gemacht werden. Dies ist eine der Möglichkeiten, um einen Freiraum für die Schwingungsfähigkeit der aktiven Resonatorfläche zu schaffen. Es ist auch eine besonders wirtschaftliche Möglichkeit, da die Bearbeitung des Kristalls ohnehin erforderlich ist, um die gewünschte Endfrequenz zu erhalten. Diese Dickenänderung der aktiven Fläche kann durch Ätzen, durch Läppen oder durch eine Laserbearbeitung, beispielsweise Excimerlaser, vorgenommen werden. Danach können die Elektroden und ihre elektrische Verbindung zu den leitenden Flächen aufgedampft werden. Selbstverständlich ist es auch möglich, die aktive Kristallfläche zur Erzielung einer Form zu bearbeiten. So sind beispielsweise konvexe Formen für niederfrequente Quarze mit Excimerlaser oder durch Stufenätzen herstellbar. Jede dieser Bearbeitungen der aktiven Kristallfläche kann dazu dienen, die gewünschten Endabmessungen und damit Endeigenschaften zu erreichen, wie Frequenz, Widerstand, C₀/C₁-Verhältnis usw.

Eine weitere Ausführungsform sieht vor, daß die leitende Schicht des Deckels ein Fenster im Bereich des Kristalls aufweist. Auch die leitende Schicht des Bodens kann ein Fenster im Bereich der Kristalls aufweisen. Dadurch läßt sich auf einfache Weise ein Freiraum für die Schwingungsfähigkeit des Kristalls herstellen, entweder, um zusätzlich zu der Dickenänderung des Kristalls weiteren Raum zu schaffen oder anstelle einer solchen Dickenänderung. Der zusätzliche Vorteil solcher Fenster besteht darin, daß unerwünschte Kapazitäten vermieden werden.

Eine weitere Ausführungsform sieht vor, daß mindestens eines der Gehäuseteile, nämlich Boden oder Deckel, aus einem durchsichtigen Material bestehen. Auf diese Weise wird es möglich, eine oder beide der Elektroden nach Zusammenfügung des Gehäuses zur Erzielung eines genauen Frequenzabgleichs mittels Laser oder mittels einer Glimmentladung nachzubearbeiten. Beispielsweise können Boden und/oder Deckel aus Glas bestehen. Zur Bearbeitung der Elektroden kann beispielsweise ein YAK-Laser eingesetzt werden. Der große Vorteil besteht darin, daß der Abgleich nach dem Verschluß des Gehäuses stattfinden kann. Auf diese Weise lassen sich Kristalle mit einer Ausgangsgenauigkeit < 5 ppm noch abgleichen, um eine Genauigkeit von weniger als 1 ppm zu erzielen.

Die Elektroden können auf dem Kristall angeordnet sein, wobei sie in der Regel jedoch nicht die gesamte aktive Kristallfläche bedecken. Eine weitere Möglichkeit besteht darin, daß die Elektroden auf der Unterseite des Deckels und auf der Oberseite des Bodens angebracht sind. Sind mehrere Kristalle vorgesehen, kann selbstverständlich auch ein Zwischenboden Träger von Elektroden sein. Durch eine solche Ausführungsform können besonders alterungsstabile Resonatoren hergestellt werden, die eine hohe Frequenzstabilität aufweisen. Auch in einem solchen Fall lassen sich die Elektroden bei durchsichtigem Gehäuse mittels Laser nacharbeiten.

Die erfindungsgemäße Sandwich-Bauweise mit der Möglichkeit, leitende Schichten für mehrere Potentiale mit der Leiterplatte zu verbinden, eröffnet auch die Möglichkeit, daß in das Gehäuse mehrere Kristalle eingefügt sind. Diese können derart angeordnet werden, daß mehrere rahmenförmige Mittelteile zwischen Boden und Deckel eingefügt sind, daß also sozusagen mehrere Resonatoren übereinandergestapelt werden. Dabei ist es auch möglich, daß sich zwischen den rahmenförmigen Mittelteilen Zwischenböden befinden, die zumindest zur Herstellung der elektrischen Verbindung des mindestens einen darüberliegenden Kristalls zur Leiterplatte leitende Flächen aufweisen. Zweckmäßigerweise ist vorgesehen, daß das Zwischenteil oben und unten jeweils eine leitende Schicht zur Bildung der jeweiligen Dichtfläche aufweist, die außerhalb der Dichtfläche zur Potentialtrennung unterbrochen ist. Dadurch können in bereits beschriebener Weise Metallschichten miteinander verbunden werden, um die Bauteile zusammenzufügen Es läßt sich somit ein kompaktes Bauelement mit beliebig vielen Resonatoren und gegebenenfalls weiteren Bauelementen ausbilden. Es kann vorgesehen sein, daß die Kristalle durch separate Anschlüsse mit der Leiterplatte verbunden sind. Der Aufbau der leitenden Schichten und der Unterbrechungen derselben kann jedoch auch derart ausgestaltet sein, daß die einzelnen Resonatoren in Reihe oder parallel geschaltet sind.

Selbstverständlich ist jedoch auch bei der erfindungsgemäßen Ausbildung des Resonators ein Freiraum für das Schwingen des Kristalls durch wannenförmige Ausnehmungen von Boden und Deckel, wie beim genannten Stand der Technik, möglich und dann zweckmäßig, wenn ein besonders großer Freiraum hergestellt werden soll.

Der Boden des Resonators kann beliebig viele Anschlußflächen zum Verlöten mit den Leiterbahnen der Leiterplatte aufweisen. Die einzige Begrenzung liegt darin, wie viele leitende Flächen der Umfang des Gehäuses aufnehmen kann.

Es ist möglich, daß alle Bauteile des Gehäuses, nämlich der Boden, eines oder mehrere der rahmenförmigen Mittelteile und gegebenenfalls auch die Zwischenböden und der Deckel aus demselben Material, z.B. aus demselben Quarz, bestehen wie der Kristall. Auf diese Weise besteht das gesamte Bauteil aus homogenem Material mit gleicher Ausdehnung, was zu besonders streßfreien Eigenschaften, insbesondere bei unterschiedlichen Betriebstemperaturen führt. Streßfreiheit bedeutet, daß keine Schubkräfte und damit kein Verbiegen des Bauelements und keine negative Beeinflussung der Schwingungen auftritt.

Die Erfindung betrifft weiterhin ein Verfahren zur Herstellung eines Resonators der oben beschriebenen Art. Dieses Verfahren weist folgende Verfahrensschritte auf:
Eine Kristallscheibe wird zum Beispiel mittels Lack oder Schablonen dort abgedeckt, wo sich die aktive Kristallfläche und die Unterbrechung zur Polaritätstrennung befinden sollen. Danach werden die nicht abgedeckten Flächen metallisiert. Ein ähnlicher Arbeitsvorgang wird auch am Boden vorgenommen, wobei durch die Metallisierungen mindestens zwei leitende Flächen hergestellt werden, die sich derart zum Fuß des Bodens erstrecken, daß dieser damit auf eine Leiterplatte auflötbar ist. Außerdem können solche Schichten im Dichtungsbereich vorgesehen werden, wobei sie mit den leitenden Schichten der Kristallscheibe korrespondieren. Auch der Deckel kann mit einer solchen Metallschicht versehen werden, die sich zumindest im Bereich der Dichtfläche des abgedichteten Gehäusebereichs befindet.

Danach wird die aktive Kristallfläche der Kristallscheibe derart freigestellt, daß mindestens ein Verbindungssteg zum dadurch entstehenden rahmenförmigen Mittelteil erhalten bleibt. Dies kann durch Bohren, Trennen mittels Trennscheibe oder Ätzen erfolgen, wobei im letzteren Fall ebenfalls eine Abdeckung mit einem Lack vorgenommen werden kann. Nach der Freistellung der aktiven Kristallfläche werden alle Flächen bis auf die aktive Kristallfläche durch einen Lack abgedeckt, damit dieser Bereich auf die gewünschte Frequenz geätzt werden kann. Es können dabei auch konvexe Formen für niederfrequente Quarze durch Stufenätzen hergestellt werden. Selbstverständlich sind auch andere Bearbeitungsformen wie mittels Laser möglich. Wesentlich ist, daß durch die so bearbeitete Kristallfläche die gewünschten Dimensionen erzielt werden. Danach werden die Elektroden so aufgebracht, daß sie mit den leitenden Dichtflächen verbunden sind.

Zum Schluß werden die Gehäuseteile zusammengefügt, wobei dies durch Kleben, Löten, Bonden oder Schweißen, beispielsweise Reibschweißen oder Laserschweißen, stattfinden kann. Dabei werden die vertikalen leitenden Flächen und gegebenenfalls auch horizontalen leitenden Schichten von Boden und Kristallscheibe, welche denselben Potentialen zugeordnet sind, miteinander verbunden. Es kann auch eine Verbindung dadurch hergestellt werden, daß die Teile unter Vakuum durch Unterdruck verschlossen werden. Besonders zweckmäßig ist eine Kombination von Verfahren, beispielsweise dahingehend, daß der Deckel und der Boden zusammen mit der Kristallscheibe unter Vakuum zusammengefügt und anschließend die Metallflächen verlötet oder verschweißt werden. Durch den zuvor erfolgten Vakuumverschluß ist der Quarz geschützt und das höhere Risiko, daß der Vakuumverschluß nicht dauerhaft ist, besteht nicht. Das Lot läßt sich beispielsweise durch einen Laser erwärmen oder es wird ein Stempel vorgesehen, der von oben und unten während des Lötvorgangs die Teile zusammenhält und gleichzeitig zur Wärmeabfuhr und zur Abdichtung nach innen dient.

Ist das Gehäuse durchsichtig, beispielsweise als Allglasgehäuse ausgebildet, so kann nach dem Zusammenfügen des Gehäuses mittels eines Lasers oder einer Glimmentladung mindestens eine der Elektroden durch den durchsichtigen Gehäuseteil hindurch nachbearbeitet werden, womit in oben dargestellter Weise eine besonders hohe Genauigkeit erzielt werden kann.

Die Erfindung wird nachstehend anhand der Zeichnung erläutert. Es sind Ausführungsbeispiele mit zweckmäßigen Ausgestaltungen und Weiterbildungen dargestellt, auf weitere Vorteile wird verwiesen. Es zeigen
- **Fig. 1**: einen Schnitt durch ein erstes Ausführungsbeispiel eines Resonators der erfindungsgemäßen Art im Bereich eines rahmenförmigen Mittelteils mit aktiver Kristallfläche,
- **Fig. 2**: einen Längsschnitt durch dieses Ausführungsbeispiel,
- **Fig. 3 u. 3a**: einen Deckel,
- **Fig. 4, 4a u. 4b**: ein rahmenförmiges Mittelteil sowie
- **Fig. 5, 5a u. 5b**: einen Boden eines zweiten Ausführungsbeispiels,
- **Fig. 6**: die Gehäuseteile eines dritten Ausführungsbeispiels zur Darstellung des Zusammenbaus,
- **Fig. 7**: ein viertes Ausführungsbeispiel mit einigen alternativen Merkmalen,
- **Fig. 8**: ein fünftes Ausführungsbeispiel mit zwei Resonatoren übereinandergestapelt,
- Fig. 9: einen Schnitt durch das obere Mittelteil der Fig. 8,
- **Fig. 10**: einen Schnitt durch den Zwischenboden der Fig. 8,
- **Fig. 11**: einen Schnitt durch das untere Mittelteil der Fig. 8 sowie
- **Fig. 12**: eine Seitenansicht des fünften Ausführungsbeispiels und
- **Fig. 13**: ein sechstes Ausführungsbeispiel.

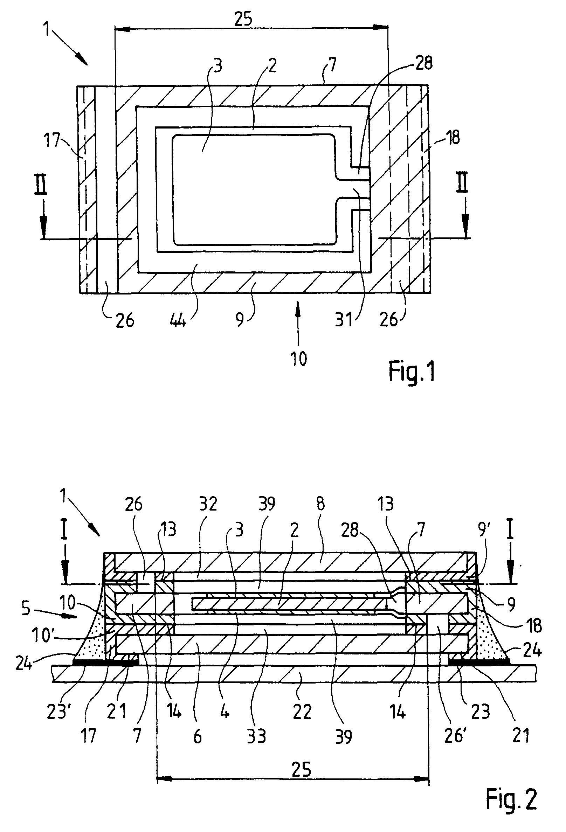

Die **Fig. 1 und 2** zeigen ein erstes Ausführungsbeispiel, an dem die Prinzipien der Erfindung erläutert werden. Das Gehäuse 5 des Resonators 1 ist aus einem Boden 6, einem rahmenförmigen Mittelteil 7 und einem Deckel 8 aufgebaut. Fig. 1 zeigt einen Schnitt I-I, der in Fig. 2 eingezeichnet ist. Er führt durch das rahmenförmige Mittelteil 7 im Bereich der leitenden Schicht 9, die der Weitervermittlung des ersten Potentials dient. Das rahmenförmige Mittelteil 7 bildet einen Rahmen und umfaßt dabei einen Kristall 2, der durch einen Verbindungssteg 28 mit dem rahmenförmigen Mittelteil 7 in Verbindung steht. Zweckmäßigerweise sind rahmenförmiges Mittelteil 7 und Kristall 2 aus einem Teil, beispielsweise einem Quarzkristall, hergestellt, wobei eine Freistellung 44 in bereits beschriebener Weise entfernt wurde. Die in Fig. 1 dargestellte Schnittfläche geht durch die leitende Schicht 9 des rahmenförmigen Mittelteils 7 hindurch, wobei zu sehen ist, daß eine Unterbrechung 26 diese leitende Schicht 9 derart aufteilt, daß ein abgedichteter Gehäusebereich 25 entsteht. Der größte Teil der leitenden Schicht 9 ist mit dem ersten Potential der senkrechten leitenden Fläche 18 verbunden. Dieser Bereich steht durch die Elektrodenzuleitung 31 mit der Elektrode 3 an der Oberseite des Kristalls 2 in Verbindung. An der Unterseite des rahmenförmigen Mittelteils 7 befindet sich die leitende Schicht 10, die der Beaufschlagung der unteren Elektrode 4 mit dem zweiten Potential dient. Bei dieser leitenden Schicht 10 verläuft die Unterbrechung 26' derart, daß die senkrechte leitende Fläche 18 des ersten Potentials abgetrennt ist. Diese Unterbrechung 26' ist in Fig. 1 mit unterbrochener Linie gezeichnet, da sie sich auf der Rückseite befindet.

Durch die Dichtflächen 13 und 14 wird ein abgedichteter Gehäusebereich 25 gebildet, in dem sich der Kristall 2 befindet. Dieser abgedichtete Gehäusebereich 25 entsteht durch den Aufbau des sandwichartigen Gehäuses 5 aus Boden 6, rahmenförmigen Mittelteil 7 und Deckel 8. Dabei sind die leitenden Schichten 9 und 10 mit leitenden Schichten 9' und 10' des Deckels 8 und des Bodens 6 in korrespondierender Weise derart zusammengefügt, daß um den Kristall 2 der hermetisch abgeschlossene Gehäusebereich 25 entsteht.

Um ein solches Bauteil SMD-fähig zu machen, war es erforderlich, es derart auszugestalten, daß die beiden Potentiale der Elektroden 3 und 4 voneinander getrennt mit Leiterbahnen 23 und 23' der Leiterplatte 22 verbunden werden können. Dazu dienen die genannte Unterbrechung 26 der leitenden Schichten 9 und 9' sowie die Unterbrechung 26' der leitenden Schichten 10 und 10' mit den separaten Anschlüssen zu den Leiterbahnen 23, 23' der Leiterplatte 22. Von der Leiterbahn 23 an der rechten Seite des Bauteils ist eine elektrische Verbindung durch die senkrechte leitende Fläche 18 des Bodens 6 zur leitenden Schicht 9 des rahmenförmigen Mittelteils 7 hergestellt. Die leitende Fläche 18 ist am Fuß 21 des Bodens 6 durch eine Lötung 24 mit der Leiterbahn 23 der Leiterplatte 22 verbunden. Dadurch gelangt das erste Potential zur Elektrode 3. Davon abgetrennt befindet sich auf der linken Seite des Bauteils das zweite Potential, welches in entsprechender Weise mit der Leiterbahn diesem 23' durch eine weitere Lötung 24 verbunden ist. Durch die Unterbrechungen 26 und 26' liegen auch die Dichtflächen 13 und 14 auf verschiedenen Potentialen. Es wäre jedoch auch eine andere als die gezeichnete Anordnung der Unterbrechungen denkbar, wesentlich ist nur, daß die Potentiale getrennt sind, ohne daß dadurch ein Lücke in den Dichtflächen 13 und 14 erzeugt wird. Auf diese Weise ist es gelungen, mittels einer Sandwich-Bauweise einen Resonator 1 herzustellen, bei dem keinerlei Drähte oder Durchkontaktierungen erforderlich sind. Allein durch die metallisierten Flächen 9, 9', 10, 10' der aufeinandergeschichteten Gehäuseteile 5, 6, 7 ist sowohl die Abdichtung eines Gehäusebereichs 25 als auch die Trennung der beiden Potentiale erzielt.

Zur schwingungsfähigen Aufhängung des Kristalls 2 sind Fenster 32 und 33 in den leitenden Schichten 9' und 10' des Bodens 6 und des Deckels 8 vorgesehen. Diese schwingungsfähige Aufhängung mit einem entsprechenden Freiraum 39 kann jedoch auch durch eine Dickenbearbeitung der aktiven Kristallfläche 2 geschaffen werden, wie es an diesem Ausführungsbeispiel ersichtlich ist. Nach dieser Dickenbearbeitung wurden die Elektroden 3 und 4 aufgebracht und mit den leitenden Schichten 9 und 10 zum Anschluß an das erste und zweite Potential verbunden.

Die Schnittdarstellung der Fig. 2 führt entlang der Linie II-II der Fig. 1, wobei Kristall 2 und Elektroden 3 und 4 geschnitten sind, jedoch nicht der Verbindungssteg 28 und die Elektrodenzuleitung 31. Nach dem dargestellten Prinzip sind auch die folgenden Ausführungsbeispiele aufgebaut, wobei durch entsprechende Ausgestaltungen weitere Vorteile erzielt werden.

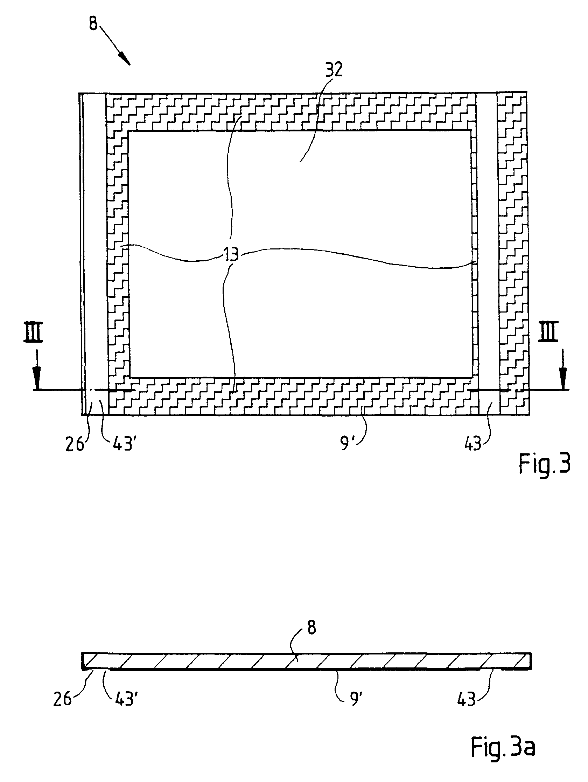

Die **Fig. 3 - 5b** zeigen die Einzelteile eines zweiten Ausführungsbeispiels, das sich vom ersten Ausführungsbeispiel dadurch unterscheidet, daß der Kristall 2 durch zwei Verbindungsstege 29 und 30 an das rahmenförmige Mittelteil 7 angebunden ist und daß der Kristall nicht oder nur unwesentlich in seiner Dicke bearbeitet wurde. Der Freiraum 39 wird dann bei diesem Ausführungsbeispiel durch die Fenster 32 und 33 geschaffen.

Zusätzlich wurden Weiterbildungen in das zweite Ausführungsbeispiel eingefügt. Die **Fig. 3 und 3a** zeigen den Deckel 8 des zweiten Ausführungsbeispiels. Dabei stellt die Fig. 3a den Schnitt III-III der Fig. 3 dar. Der Deckel 8 trägt an seiner Unterseite eine leitende Schicht 9', die der oben beschriebenen entspricht und die ein Fenster 32 aufweist. Zur Verdeutlichung ist die in der Ansicht der Fig. 3 sichtbare leitende Schicht 9' mit Wellenlinien markiert. Dabei ist die Unterbrechung 26 sichtbar, die der Trennung der Potentiale in beschriebener Weise dient. Weitere Unterbrechungen 43 und 43', letztere als Verbreiterung der Unterbrechung 26 ausgeführt, korrespondieren mit entsprechenden Unterbrechungen 43, 43' der leitenden Schicht 9 des rahmenförmigen Mittelteils 7. Ihre Funktion wird unten beschrieben. Das Bezugszeichen 13 zeigt die Dichtfläche, die mit dem Mittelteil 7 zusammenwirkend die Abdichtung zwischen Deckel 8 und rahmenförmigen Mittelteil 7 bewirkt.

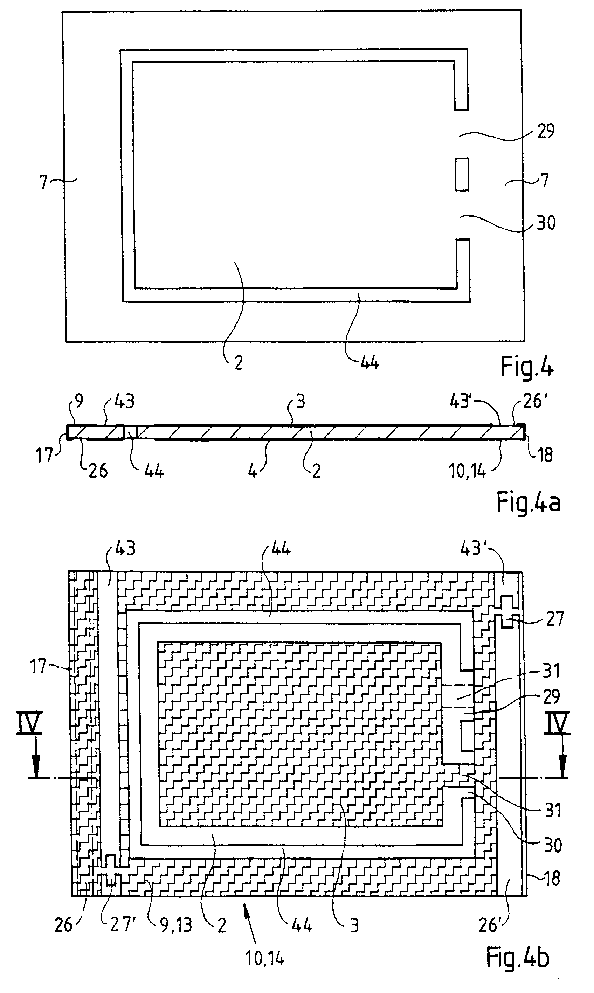

Die **Fig. 4a und 4b** zeigen das rahmenförmige Mittelteil 7, wobei die Fig. 4 die noch nicht mit leitenden Schichten versehene Quarzscheibe darstellt, bei der jedoch bereits durch die Freistellung 44 die aktive Kristallfläche 2 herausgearbeitet wurde. Sie ist durch die Verbindungsstege 29 und 30 an das rahmenförmige Teil 7 angefügt. Die Fig. 4b zeigt das rahmenförmige Mittelteil 7 nach der Aufbringung der leitenden Schicht 9, welche gleichzeitig die Dichtfläche 13 mit dem bereits beschriebenen Deckel 8 ergibt. Unterhalb des dargestellten rahmenförmigen Mittelteils 7 befindet sich die leitende Schicht 10, die gleichzeitig die Dichtfläche 14 mit dem noch zu beschreibenden Boden 6 ergibt. Im Gegensatz zum oben beschriebenen befindet sich bei diesem Ausführungsbeispiel die Elektrodenzuleitung 31 für die obere Elektrode 3 auf einem Verbindungssteg 30 und die Elektrodenzuleitung 31 für die Elektrode 4 auf dem anderen Verbindungssteg 29. Durch diese Ausgestaltung werden unerwünschte Resonanzen bei den Zuführungen vermieden. Selbstverständlich sind auch andere Anbindungen der aktiven Kristallfläche 2 möglich, dies hängt von den jeweiligen gewünschten Schwingungsformen und davon ab, unter welchem Winkel der Kristall zur Herstellung des Blanks geschnitten wurde.

Als weitere Besonderheit weist die zweite Ausführungsform eine Unterbrechung 43 der beiden leitenden Schichten 9 und 9' auf. In dieser Unterbrechung 43 können Bauelemente 27' angeordnet sein, die in Reihe zum Kristall 2 geschaltet sind. Zusätzlich ist noch eine weitere Unterbrechung 43' vorgesehen, die die Unterbrechung 26' derart vergrößert, daß eines oder mehrere weitere Bauelemente 27 eingefügt werden können, welche parallel zum Kristall 2 angeordnet sind. Auf diese Weise können Leiterbahnen, Spulen oder Kondensatoren zusätzlich in den Resonator integriert werden, und es ist auf diese Weise möglich, einen Quarzfilter ganz oder teilweise in das Gehäuse 5 des Resonators 1 zu integrieren.

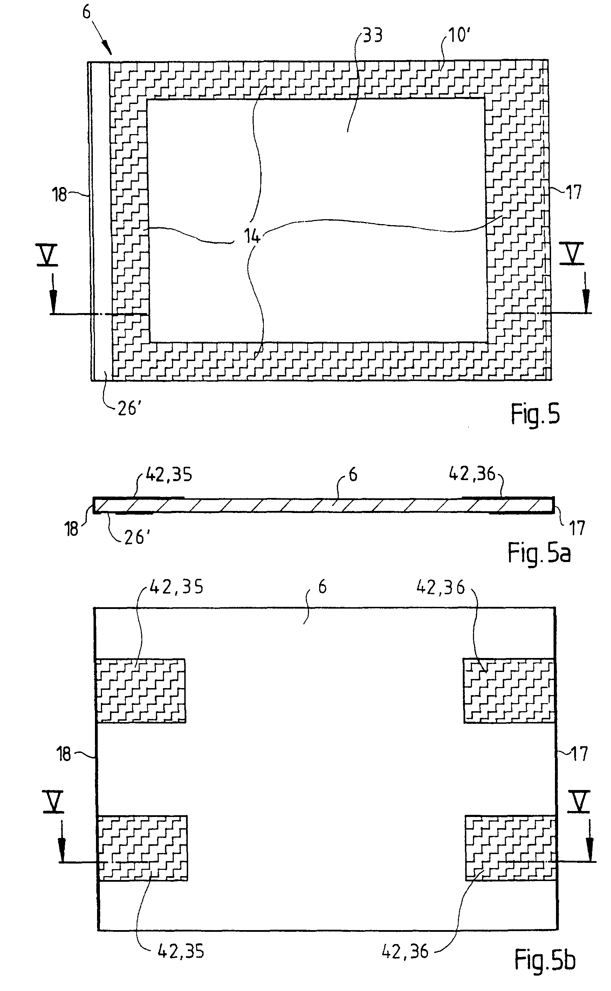

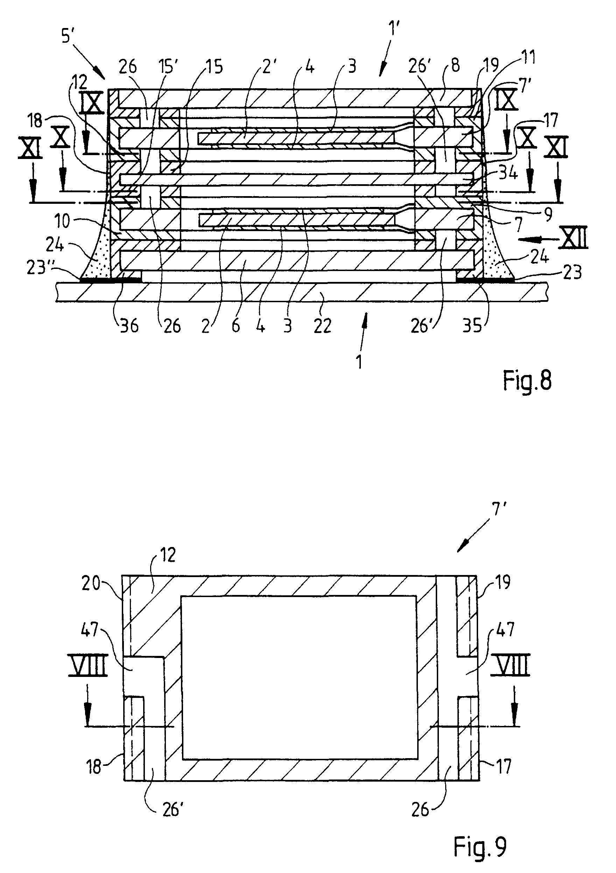

Die **Fig. 5, 5a und 5b** zeigen den Boden 6 des zweiten Ausführungsbeispiels. Fig. 5 zeigt die Oberseite des Bodens 6, wobei die leitende Schicht 10' derart ausgestaltet wurde, daß sie mit der leitenden Schicht 10 des rahmenförmigen Mittelteils 7 korrespondiert. Diese Übereinstimmung muß im Bereich der Dichtfläche 14 und in einem Kontaktbereich realisiert sein. Ansonsten sind auch hier weitere Unterbrechungen 43 und 43' möglich. Solche sind jedoch nicht dargestellt. Die Fig. 5a zeigt einen Schnitt V-V durch den Boden 6. An der Unterseite des Bodens befinden sich Anschlußflächen 42 wobei es sich bei diesem Ausführungsbeispiel um zwei separate Anschlüsse 35 und 36 handelt. Selbstverständlich können mehrere solche Anschlußflächen 42 in einem anderen Ausführungsbeispiel wie dem der Fig. 8 dazu dienen, daß vier Potentiale angeschlossen werden können. Die hier dargestellten zwei separaten Anschlüsse 35 und 36 sind durch senkrechte leitende Flächen 17 und 18 zur Oberseite des Bodens 6 gezogen, an der sich die leitende Schicht 10' für das zweite Potential befindet. Durch die Unterbrechung 26' ist jedoch die leitende Fläche 18 abgetrennt, sie dient der Verbindung der leitenden Schicht 9 des rahmenförmigen Mittelteils 7 zum Anschluß der oberen Elektrode 3. Dagegen führt die leitende Fläche 17 über die leitende Schicht 10 und 10' zur unteren Elektrode 4.

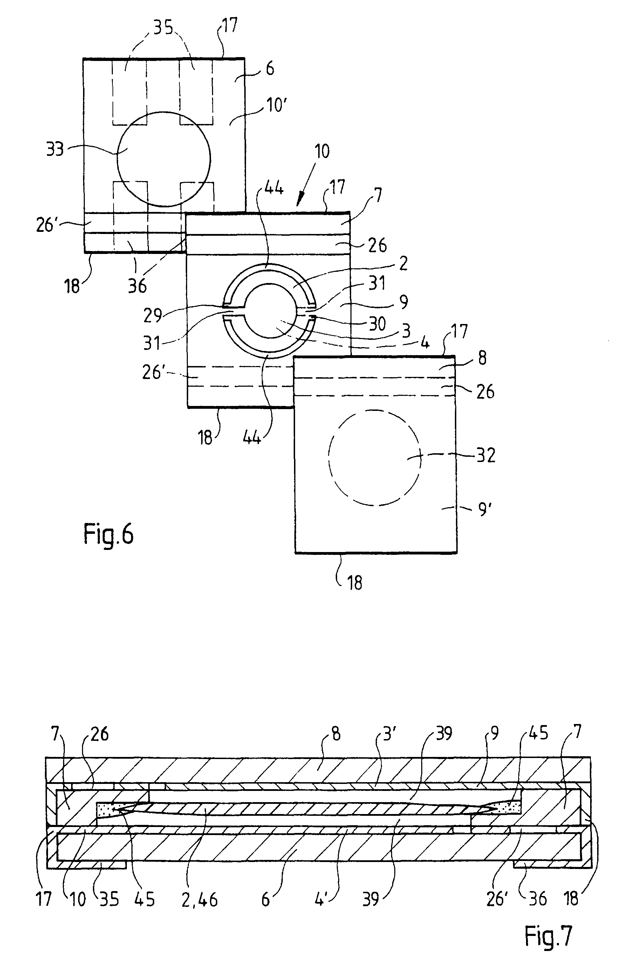

**Fig. 6** zeigt Gehäuseteile eines dritten Ausführungsbeispiels zur Darstellung des Zusammenbaus. Bei diesem Ausführungsbeispiel ist der Kristall 2 rund ausgebildet und weist zwei sich gegenüberliegende Verbindungsstege 29 und 30 auf, so daß sich die Freistellung 44 über ca. 2 mal 175 Grad erstrecken. Der Boden 6 hat an seiner Oberseite die leitende Schicht 10', die ein Fenster 33 aufweist, das in diesem Fall rund ausgestaltet ist. Die leitende Schicht 10' ist weiterhin mit der Unterbrechung 26' versehen, die mit der entsprechenden Unterbrechung 26' der Schicht 10 des rahmenförmigen Mittelteils 7 korrespondiert. Dieses Mittelteil 7 weist an seiner Oberseite die leitende Schicht 9 mit der Unterbrechung 26 auf, die wiederum mit der Unterbrechung 26 der Schicht 9' des Deckels 8 korrespondiert. Diese Schicht 9' weist wiederum ein Fenster 32 auf, das genauso wie das Fenster 33 die Größe der Freistellung 44 hat. Beim Aufeinandersetzen von Boden 6, rahmenförmigem Mittelteil 7 und Deckel 8 ergibt sich somit eine Verbindung von der Elektrode 3 über die Elektrodenzuleitung 31 und die leitende Fläche 18 zu den Anschlüssen 36. Die unterhalb des Kristalls 2 liegende Elektrode 4 ist über deren Elektrodenzuleitung 31, die Schicht 10 und 10' und die leitende Fläche 17 mit den Anschlüssen 35 verbunden. Die beiden Potentiale sind durch die Unterbrechungen 26 und 26' voneinander getrennt. Durch die Anordnung dieser Unterbrechungen 26 und 26' wird der abgedichtete Gehäusebereich, der die Freistellung 44 umschließt, nicht berührt. Die übrigen Bezugszeichen entsprechen den Teilen, die bereits bei den vorigen Ausführungsbeispielen erwähnt wurden.

**Fig. 7** zeigt ein viertes Ausführungsbeispiel mit einigen alternativen Merkmalen. Dieses Ausführungsbeispiel weist ein rahmenförmiges Mittelteil 7 auf, in das ein linsenförmiger Quarzkristall 46 mittels einer Klebverbindung 45 befestigt ist. Ein linsenförmiger Quarzkristall 46 eignet sich speziell für Quarze < 12 MHz. Das rahmenförmige Mittelteil 7 weist an einem Außenrand eine leitende Fläche 18 und am anderen Außenrand eine leitende Fläche 17 auf. Der Boden 6 hat Anschlüsse 35 und 36, wobei der Anschluß 35 über die leitende Fläche 17 und die leitende Schicht 10 zur unteren Elektrode 4' führt. Der Anschluß 36 führt über die leitende Fläche 18 und die leitende Schicht 9 zur oberen Elektrode 3'. Bei diesem Ausführungsbeispiel sind die Elektroden 3' und 4' nicht am Kristall 2 angebracht, sondern sie befinden sich am Boden 6 und am Deckel 8. Eine derartige Anordnung führt zu einer hohen Frequenz- und Langzeitstabilität. Es sind Unterbrechungen 26 und 26' vorgesehen, um die beiden Potentiale voneinander zu trennen. Statt der Unterbrechung 26 könnte jedoch auch die leitende Fläche 17 an dem rahmenförmigen Mittelteil 7 weggelassen werden, so daß diese fehlende leitende Fläche 17 sozusagen die Unterbrechung 26 darstellen würde. Selbstverständlich könnte dieses Bauteil auch als Bauteil mit mehreren Resonatoren aufeinandergestapelt aufgebaut werden, für diesen Fall wären auch an Zwischenböden zwischen den einzelnen Resonatoren Elektroden in entsprechender Weise anzuordnen. Bei diesem dritten Ausführungsbeispiel wurden viele abweichende Merkmale zusammengefaßt, was selbstverständlich nicht bedeutet, daß diese nur in der dargestellten Kombination möglich sind. Verschiedene Merkmale aller dargestellten Ausführungsbeispiele lassen sich in unterschiedlicher Weise miteinander kombinieren.

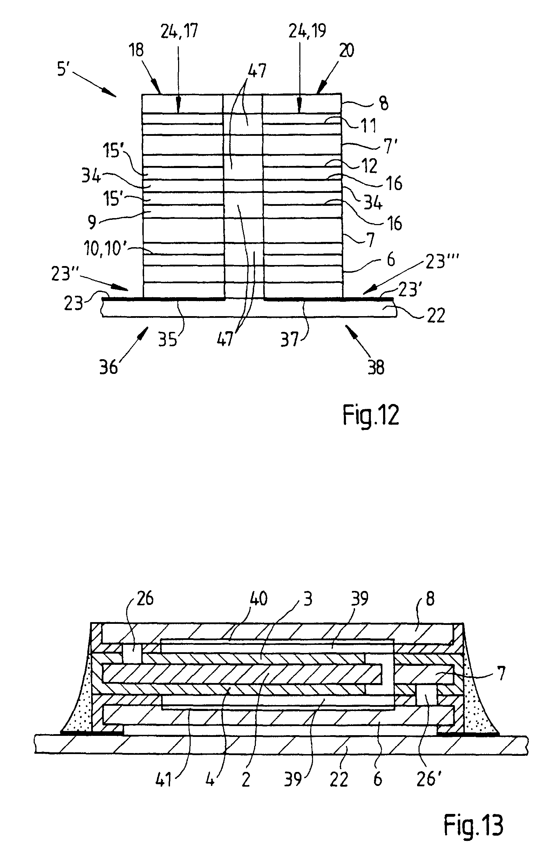

Die **Fig. 8 bis 12** zeigen ein fünftes Ausführungsbeispiel mit zwei übereinandergestapelten Resonatoren 1, 1', die sich in einem Gehäuse 5' befinden. Die Fig. 8 bis 11 sind Schnittdarstellungen, wobei die Schnitte der Fig. 9, 10 und 11 in der Fig. 8 eingetragen sind. Der Verlauf des Schnitts der Fig. 8 ist wiederum in den Fig. 9 bis 11 vermerkt. Die römischen Ziffern der Schnitte entsprechen den arabischen Zahlen der Figuren. Bei der Fig. 12 handelt es sich um eine Seitenansicht, die ebenfalls in römischer Ziffer mit Pfeil in der Fig. 8 angezeigt wird.

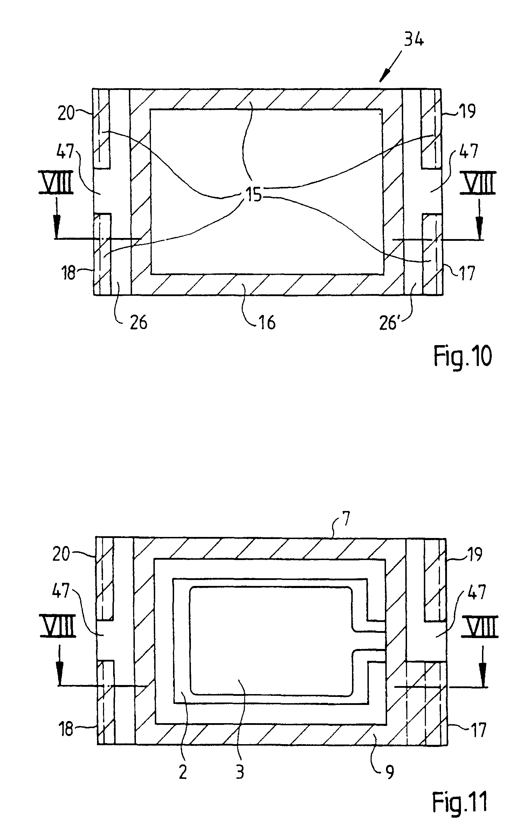

Bei diesem Ausführungsbeispiel weist jeder Resonator 1 und 1' separate Anschlüsse 35 und 36 sowie 37 und 38 zur Leiterplatte 22 auf. So führt von der Leiterbahn 23 der Anschluß 35 über die leitende Fläche 17 und die leitende Schicht 9 zur oberen Elektrode 3 des Kristalls 2. Von der Leiterbahn 23" führt der Anschluß 36 über die leitende Fläche 18 und die leitende Schicht 10 zur unteren Elektrode 4 des Kristalls 2. Weiterhin führt von der Leiterbahn 23' der Anschluß 37 über die leitende Fläche 19 und die leitende Schicht 11 zur oberen Elektrode 3 des Kristalls 2', und schließlich führt von der Leiterbahn 23''' der Anschluß 38 über die leitende Fläche 20 und die leitende Schicht 12 zur unteren Elektrode 4 des Kristalls 2'. Um diese vier separaten Anschlüsse 35 bis 38 zu erzielen, müssen zu den Unterbrechungen 26 und 26' weitere Unterbrechungen 47 vorgesehen sein, die sich an die Unterbrechungen 26 und 26' derart anfügen, daß die leitenden Seitenflächen des Bauteils in vier leitende Flächen 17 bis 20 aufgeteilt werden, wobei jede dieser Flächen 17 bis 20 mit je einer leitenden Schicht 9 bis 12 in oben genannter Weise verbunden ist. So zeigt der in Fig. 9 dargestellte Schnitt IX, daß die leitende Fläche 20 zur leitenden Schicht 12 durchverbunden ist. In entsprechender Weise ist an der oberen Seite des Resonators 1' die leitende Fläche 19 mit der leitenden Schicht 11 verbunden. Die Fig. 11 zeigt, wie die leitende Fläche 17 mit der leitenden Schicht 9 verbunden ist, und entsprechend ist auch die leitende Fläche 18 mit der leitenden Schicht 10 verbunden. Zwischen den Resonatoren 1 und 1' befindet sich ein Zwischenboden, der leitende Schichten 15 und 15' aufweist, welche beide derart ausgestaltet sind, wie dies in Fig. 10 gezeigt ist. Die Dichtflächen 16 des Zwischenbodens 34 sind durch die Unterbrechungen 26 und 26' von den Potentialen getrennt. Die zwei Potentiale jeder Seite sind wiederum durch die weiteren Unterbrechungen 47 getrennt. Auf diese Weise werden die Potentiale lediglich weitergeführt, ohne daß eine Kontaktierung mit der größeren Dichtfläche 16 stattfindet. Selbstverständlich könnten die leitenden Flächen 17 und 18 mit den entsprechenden Teilen der leitenden Schicht auch weggelassen werden, da eine Verbindung nach oben nicht erforderlich ist. Es wäre auch möglich, die Unterbrechungen 26, 26', 47 bei dem Zwischenboden 34 dort wegzulassen, wo die korrespondierenden Flächen 9, 10, 11, 12 der angrenzenden rahmenförmigen Mittelteile 7, 7' keine solchen aufweisen. Die dargestellte Ausführung wurde gewählt, um aufgrund der allseitigen Symmetrie eine bessere Handhabung und universelle Einsetzbarkeit des Zwischenbodens 34 zu erzielen und die Lötungen 24 ebenfalls in symmetrischer Weise an dem Bauteil hochführend anbringen zu können.

Selbstverständlich läßt sich auch ein Stapel mit mehr als zwei Resonatoren herstellen, wobei jedoch noch zusätzliche Unterbrechungen 47 erforderlich wären. Es ist auch vorstellbar, daß die noch nicht mit leitenden Flächen 17 bis 20 versehenen Seiten entsprechend herangezogen werden, um noch mehr Kontaktierungen zu ermöglichen. Weiterhin ist vorstellbar, daß die rahmenförmigen Mittelteile 7 und 7' ohne Zwischenboden 34 aufeinandergestapelt werden. In diesem Fall würden sich alle Kristalle in einem abgedichteten Gehäusebereich befinden.

Bei dem dargestellten fünften Ausführungsbeispiel sind die Anschlüsse der beiden Resonatoren 1 und 1' separat zur Leiterplatte geführt. Mit entsprechenden Verbindungen zwischen den leitenden Flächen 17 bis 20 und den leitenden Schichten 9 bis 13 sind jedoch auch Gehäuse mit parallelgeschalteten oder hintereinandergeschalteten Resonatoren möglich und Schaltungen mit weiteren Bauelementen 27 realisierbar.

**Fig. 13** zeigt noch ein sechstes Ausführungsbeispiel, das sich gegenüber der Fig. 2 darin unterscheidet, daß die Elektrode 2 die Dicke des rahmenförmigen Mittelteils 7 aufweist und zur Erzielung des Freiraums 39 wannenförmige Ausnehmungen 40 und 41 des Deckels 8 und des Bodens 6 vorgesehen sind.

Die in den Figuren gezeigten sechs Ausführungsbeispiele stellen lediglich beispielhafte Zusammenfügungen von Merkmalen dar. Selbstverständlich sind beliebige Merkmalskombinationen möglich.

### Resonator mit Kristall

### Bezugszeichenliste

- 1, 1': Resonator
- 2, 2': Kristall (bzw. aktive Kristallfläche)
- 3, 3': Elektrode (oben)
- 4, 4': Elektrode (unten)
- 5, 5': Gehäuse
- 6: Boden
- 7,7': rahmenförmiges Mittelteil (z.B. Kristallscheibe)
- 8: Deckel
- 9, 9': leitende Schicht, erstes Potential
- 10, 10': leitende Schicht, zweites Potential
- 11: leitende Schicht, drittes Potential
- 12: leitende Schicht, viertes Potential
- 13: Dichtfläche, Oberseite des Mittelteils
- 14: Dichtfläche, Unterseite des Mittelteils
- 15, 15': leitende Schichten des Zwischenbodens
- 16: Dichtflächen des Zwischenbodens
- 17, 18, 19, 20: leitende Flächen
- 21: Fuß des Bodens
- 22: Leiterplatte
- 23, 23', 23'', 23''': Leiterbahnen der Leiterplatte
- 24: Lötung
- 25: durch Dichtflächen abgedichteter Gehäusebereich
- 26, 26': Unterbrechungen einer leitenden Schicht
- 27, 27': weitere Bauelemente
- 28: Verbindungssteg (einer)
- 29, 30: Verbindungsstege (zwei)
- 31: Elektrodenzuleitung
- 32: Fenster (Deckel)
- 33: Fenster (Boden)
- 34: Zwischenboden
- 35, 36, 37, 38: separate Anschlüsse
- 39: Freiraum
- 40, 41: wannenförmige Ausnehmungen
- 42: Anschlußflächen
- 43, 43': weitere Unterbrechung einer leitenden Schicht
- 44: Freistellung
- 45: Klebverbindung
- 46: linsenförmiger Quarzkristall
- 47: weitere Unterbrechungen leitender Schichten zur Trennung von 4 Potentialen

## Patentansprüche

1. Resonator (1) mit mindestens einem Kristall (2, 2'), mindestens zwei diesen Kristall (2, 2') anregenden Elektroden (3, 3', 4, 4') und einem in Sandwich-Bauweise aufgebauten Gehäuse (5, 5') mit einem im wesentlichen scheibenförmigen Boden (6), mindestens einem rahmenförmigen Mittelteil (7, 7'), das den Kristall (2, 2') umgibt und in schwingfähiger Weise trägt, und einem im wesentlichen scheibenförmigen Deckel (8), wobei diese Gehäuseteile (6, 7, 7', 8) unter Einschluß von leitenden Schichten (9 und 9', 10 und 10'; 11, 12) durch Dichtflächen ( 13, 14, 15, 16) miteinander verbunden sind und die Elektroden (3, 4; 3', 4') jeweils mit einer leitenden Schicht (9 und 9', 10 und 10'; 11, 12) elektrisch in Verbindung stehen,
**dadurch gekennzeichnet,**
daß sich an mindestens einer Seite des Gehäuses (5, 5') insgesamt mindestens zwei leitende Flächen (17, 18, 19, 20) derart zum Fuß (21) des Bodens (6) erstrecken, daß dieser damit auf eine Leiterplatte (22) auflötbar ist, wobei die leitenden Schichten (9 und 9', 10 und 10'; 11, 12) jeweils außerhalb der Dichtflächen (13, 14, 15, 16), die der Erzielung eines abgedichteten Gehäusebereichs (25) dienen, zur Potentialtrennung unterbrochen sind.

2. Resonator nach Anspruch 1,
**dadurch gekennzeichnet,**
daß sich die leitenden Schichten (9, 10) auf dem mindestens einen rahmenförmigen Mittelteil (7) befinden, wobei diese mit Boden (6) und Deckel (8) zur Herstellung der Dichtflächen (11, 12, 13, 14) verbunden werden.

3. Resonator nach Anspruch 2,
**dadurch gekennzeichnet,**
daß der Deckel (8) und das Mittelteil (7) durch Bonden miteinander verbunden werden.

4. Resonator nach Anspruch 2 oder 3,
**dadurch gekennzeichnet,**
daß der Boden (6) und das Mittelteil (7) durch Bonden miteinander verbunden werden.

5. Resonator nach Anspruch 2 oder 3,
**dadurch gekennzeichnet,**
daß der Boden (6) oben eine leitende Schicht (10') aufweist, die mit der entsprechenden leitenden Schicht (10) des Mittelteils (7) verbunden ist, wobei diese mindestens im Bereich der Dichtfläche (14) korrespondieren.

6. Resonator nach Anspruch 2, 4 oder 5,
**dadurch gekennzeichnet,**
daß der Deckel (8) unten eine leitende Schicht (9') aufweist, die mit der entsprechenden Schicht (9) des Mittelteils (7) verbunden ist, wobei diese mindestens im Bereich der Dichtfläche (13) korrespondieren.

7. Resonator nach einem der Ansprüche 1 bis 6,
**dadurch gekennzeichnet,**
daß die leitenden Schichten (9, 9'; 10, 10'; 11 oder 12) außerhalb der Dichtflächen (13, 14, 15 oder 16) weitere Unterbrechungen (43, 43') aufweisen.

8. Resonator nach Anspruch 7,
**dadurch gekennzeichnet,**
daß die weiteren Unterbrechungen (43, 43') der Aufnahme weiterer Bauelemente (27, 27') dienen.

9. Resonator nach einem oder mehreren der Ansprüche 1 bis 8,
**dadurch gekennzeichnet,**
daß der Kristall (2, 2') und das rahmenförmige Mittelteil (7, 7') als einstückiges Bauteil ausgebildet sind, wobei die aktive Resonatorfläche des Kristalls (2, 2') unter Verbleib von mindestens einem Verbindungssteg (28, 29, 30) freigestellt ist.

10. Resonator nach Anspruch 9,
**dadurch gekennzeichnet,**
daß zwei Verbindungsstege (29, 30) vorgesehen sind, die mindestens je eine Elektrodenzuleitung (31) tragen.

11. Resonator nach einem oder mehreren der Ansprüche 1 bis 9,
**dadurch gekennzeichnet,**
daß die aktive Kristallfläche (2, 2') zur Erzielung einer Dickenänderung bearbeitet ist.

12. Resonator nach Anspruch 11,
**dadurch gekennzeichnet**,
daß durch die Dickenänderung der Freiraum (39) für die Schwingungen des Kristalls (2,2') geschaffen ist.

13. Resonator nach einem oder mehreren der Ansprüche 1 bis 12,
**dadurch gekennzeichnet,**
daß die aktive Kristallfläche (2, 2') zur Erzielung einer Form bearbeitet ist.

14. Resonator nach einem oder mehreren der Ansprüche 11 bis 13,
**dadurch gekennzeichnet,**
daß durch die Bearbeitung der aktiven Kristallfläche (2, 2') die gewünschte Frequenz erzielt ist.

15. Resonator nach einem oder mehreren der Ansprüche 6 bis 14,
**dadurch gekennzeichnet,**
daß die leitende Schicht (9') des Deckels (8) ein Fenster (32) im Bereich des Kristalls (2, 2') aufweist.

16. Resonator nach einem oder mehreren der Ansprüche 3 oder 5 bis 13,
**dadurch gekennzeichnet,**
daß die leitende Schicht (10') des Bodens (6) ein Fenster (33) im Bereich des Kristalls (2, 2') aufweist.

17. Resonator nach Anspruch 15 und 16,
**dadurch gekennzeichnet,**
daß der Freiraum (39) für die Schwingungen des Kristalls (2, 2') durch die Fenster (32, 33) hergestellt ist.

18. Resonator nach einem oder mehreren der Ansprüche 1 bis 17,
**dadurch gekennzeichnet,**
daß mindestens eines der Gehäuseteile Boden (6) oder Deckel (8) aus einem durchsichtigen Material besteht.

19. Resonator nach Anspruch 18,
**dadurch gekennzeichnet,**
daß mindestens eine der Elektroden (3, 3', 4, 4') nach der Zusammenfügung des Gehäuses (5, 5') zur Erzielung eines genauen Frequenzabgleichs mittels eines Lasers nachbearbeitet ist.

20. Resonator nach Anspruch 18,
**dadurch gekennzeichnet,**
daß mindestens eine der Elektroden (3, 3', 4, 4') nach der Zusammenfügung des Gehäuses (5, 5') zur Erzielung eines genauen Frequenzabgleichs mittels einer Glimmentladung nachbearbeitet ist.

21. Resonator nach einem oder mehreren der Ansprüche 1 bis 20,
**dadurch gekennzeichnet,**
daß die Elektroden (3, 3', 4, 4') auf dem Kristall (2, 2') angeordnet sind.

22. Resonator nach einem oder mehreren der Ansprüche 1 bis 20,
**dadurch gekennzeichnet,**
daß die Elektroden (3, 3', 4, 4') auf der Unterseite des Deckels (8) und auf der Oberseite des Bodens (6) angebracht sind.

23. Resonator nach einem oder mehreren der Ansprüche 1 bis 22,
**dadurch gekennzeichnet,**
daß in das Gehäuse (5') mehrere Kristalle (2, 2') eingefügt sind.

24. Resonator nach Anspruch 23,
**dadurch gekennzeichnet,**
daß mehrere rahmenförmige Mittelteile (7, 7') zwischen Boden (6) und Deckel (8) eingefügt sind.

25. Resonator nach Anspruch 24,
**dadurch gekennzeichnet,**
daß sich zwischen den rahmenförmigen Mittelteilen (7, 7') Zwischenböden (34) befinden, die zumindest zur Herstellung der elektrischen Verbindung des mindestens einen darüberliegenden Kristalls (2') zur Leiterplatte (22) leitende Flächen (17, 28, 19, 20) aufweisen.

26. Resonator nach Anspruch 25,
**dadurch gekennzeichnet,**
daß das Zwischenteil (34) oben und unten jeweils eine leitende Schicht (15, 15') zur Bildung der jeweiligen Dichtfläche (16) aufweist, die außerhalb der Dichtfläche (16) zur Potentialtrennung unterbrochen (26, 26', 47) ist.

27. Resonator nach einem oder mehreren der Ansprüche 23 bis 26,
**dadurch gekennzeichnet,**
daß die Kristalle (2, 2') durch separate Anschlüsse (35, 36, 37, 38) mit der Leiterplatte (22) verbunden sind.

28. Resonator nach einem oder mehreren der Ansprüche 23 bis 26,
**dadurch gekennzeichnet,**
daß die einzelnen Resonatoren (1, 1') in Reihe geschaltet sind.

29. Resonator nach einem oder mehreren der Ansprüche 23 bis 26,
**dadurch gekennzeichnet,**
daß die einzelnen Resonatoren (1, 1') parallel geschaltet sind.

30. Resonator nach einem oder mehreren der Ansprüche 1 bis 29,
**dadurch gekennzeichnet,**
daß der Freiraum (39) für das Schwingen des Kristalls (2, 2') durch wannenförmige Ausnehmungen (40, 41) von Boden (6) und Deckel (8) gebildet wird.

31. Resonator nach einem oder mehreren der Ansprüche 1 bis 30,
**dadurch gekennzeichnet,**
daß der Boden (6) Anschlußflächen (42) zum Verlöten mit den Leiterbahnen (23, 23', 23", 23"') der Leiterplatte (22) aufweist.

32. Resonator nach einem oder mehreren der Ansprüche 1 bis 31,
**dadurch gekennzeichnet,**
daß alle Bauteile (6, 7, 7', 8, 34) des Gehäuses (5, 5') aus demselben Quarzmaterial bestehen wie der Kristall (2, 2').

33. Verfahren zur Herstellung eines Resonators (1, 1') mit mindestens einem Mittelteil (7, 7') aus einer Kristallscheibe mit zwei Elektroden (3, 3', 4, 4') sowie einem Boden (6) und einem Deckel (8) durch folgende Verfahrensschritte:
a) die aktive Kristallfläche (2; 2') wird derart freigestellt, daß mindestens ein Verbindungssteg (28, 29,30) zum dadurch entstehenden rahmenförmigen Mittelteil (7, 7') erhalten bleibt.
b) die aktive Kristallfläche (2, 2') wird derart bearbeitet, daß die gewünschte mechanische Abmessung erzielt ist,
c) die Elektroden (3, 3') werden aufgebracht und gegebenenfalls zum Abgleich bearbeitet sowie mit den leitenden Schichten (9, 10, 11, 12) verbunden, das mindestens eine Mittelteil (7, 7'), der Boden ( 6) und der Deckel (8) werden zusammengefügt,
**dadurch gekennzeichnet,**
daß vor dem Zusammenfügen mindestens eine Kristallscheibe (7, 7') beidseitig mit leitenden Schichten (9, 10, 11, 12) versehen wird, wobei die aktive Kristallfläche (2, 2') und mindestens eine Unterbrechung (26, 26', 47) außerhalb von Dichtflächen (13, 14, 15, 16), die der Erzielung eines abgedichteten Gehäusebereichs (25) dienen, ausgespart bleiben, und zumindest der Boden (6) mit mindestens zwei leitenden Flächen (17, 18, 19, 20) versehen wird, die sich derart zum Fuß (21) des Bodens (6) erstrecken, daß dieser damit auf eine Leiterplatte (22) auflötbar ist und elekrische Verbindungen zu den leitenden Schichten (9, 10, 11, 12) der mindestens einen Kristallscheibe (7, 7') herstellbar sind.

34. Verfahren nach Anspruch 33,
**dadurch gekennzeichnet,**
daß auch Boden (6) und Deckel (8) mindestens im Bereich der Dichtflächen (13, 14) mit leitenden Schichten (9', 10') versehen werden und daß beim Zusammenfügen die leitenden Schichten (9, 10) der Kristallscheibe (7, 7') mit den leitenden Schichten (9', 10') von Boden (6) und Deckel (8) verbunden werden.

35. Verfahren nach Anspruch 33 oder 34,
**dadurch gekennzeichnet,**
daß mittels eines Lasers mindestens eine der Elektroden (3, 3', 4, 4') durch ein durchsichtiges Gehäuseteil (6, 8) hindurch nachbearbeitet wird.

36. Verfahren nach Anspruch 33 oder 34,
**dadurch gekennzeichnet,**
daß mittels einer Glimmentladung mindestens eine der Elektroden (3, 3', 4, 4') durch ein durchsichtiges Gehäuseteil (6, 8) hindurch nachbearbeitet wird.

37. Verfahren nach einem der Ansprüche 33 bis 36,
**dadurch gekennzeichnet,**
daß die Gehäuseteile (6, 8, 7, 7', 34) unter Vakuum durch Unterdruck verschlossen und dann durch eine weitere Verbindungstechnik miteinander verbunden werden.

## Claims

1. A resonator (1) having at least one crystal (2, 2') at least two electrodes (3, 3', 4, 4') exciting this crystal (2, 2') and a housing (5, 5') constructed in a sandwich-type manner having a substantially plate-shaped bottom (6), at least one frame-shaped central
portion (7, 7') which surrounds the crystal (2, 2') and supports same in a vibration-capable fashion and a substantially plate-shaped lid (8), wherein these housing components (6, 7, 7', 8) are connected to each other via sealing surfaces (13, 14, 15, 16) with the inclusion of conducting layers (9 and 9', 10 and 10'; 11, 12) and each electrode (3, 4; 3', 4') is electrically connected to a conducting layer (9 and 9', 10 and 10'; 11, 12),
characterized in that
at least two conducting surfaces (17, 18, 19, 20) extend at at least one side of the housing (5, 5') to the foot (21) of the bottom (6) in such a fashion that the bottom (6) can be soldered to a circuit board (22), wherein the conducting layers (9 and 9', 10 and 10'; 11, 12) are each interrupted for potential separation outside of the sealing surfaces (13, 14, 15, 16) effecting a sealed housing region (25).

2. Resonator according to claim 1,
characterized in that
the conducting layers (9, 10) are located on the at least one frame-shaped central portion (7), and are connected to the bottom (6) and the lid (8) for effecting the sealing surfaces (11, 12, 13, 14).

3. Resonator according to claim 2,
characterized in that
the lid (8) and the central portion (7) are connected to each other by means of bonding.

4. Resonator according to claim 2 or 3,
characterized in that
the bottom (6) and the central portion (7) are connected to each other by means of bonding.

5. Resonator according to claim 2 or 3,
characterized in that
the bottom (6) has an upper conducting layer (10') which is connected to the corresponding conducting layer (10) of the central portion (7), wherein the layers correspond to each other, at least in the vicinity of the sealing surface (14).

6. Resonator according to claim 2, 4 or 5,
characterized in that
the lid (8) has a lower conducting layer (9') which is connected to the corresponding layer (9) of the central portion (7), wherein the layers correspond at least in the vicinity of the sealing surface (13).

7. Resonator according to one or more of the claims 1 through 6,
characterized in that
the conducting layers (9, 9'; 10, 10'; 11 or 12) have additional separations (43, 43') outside the sealing surfaces (13, 14, 15 or 16).

8. Resonator according to claim 7,
characterized in that
the additional separations (43, 43') serve for accepting additional components (27, 27').

9. Resonator according to one or more of the claims 1 through 8,
characterized in that
the crystal (2, 2') and the frame-shaped central portion (7, 7') are configured as a single component, wherein the active resonating surface of the crystal (2, 2') is freed with at least one remaining connecting brace (28, 29, 30).

10. Resonator of claim 9,
characterized in that
two connecting braces (29, 30) are provided for which each carry at least one electrode lead (31).

11. Resonator according to one or more of the claims 1 through 9,
characterized in that
the active crystal surface (2, 2') is processed to achieve a thickness change.

12. Resonator according to claim 11
characterized in that
the thickness change creates the free space (39) for vibration of the crystal (2, 2').

13. Resonator according to one or more of the claims 1 through 12,
characterized in that
the active crystal surface (2, 2') is processed to effect a certain shape.

14. Resonator according to one or more of the claims 11 through 13,
characterized in that
the desired frequency is effected through processing of the active crystal surface (2, 2').

15. Resonator according to one or more of the claims 6 through 14,
characterized in that
the conducting layers (9') of the lid (8) have a window (32) in the vicinity of the crystal (2, 2').

16. Resonator according to one or more of the claims 3 or 5 through 13,
characterized in that
the conducting layer (10') of the bottom (6) has a window (33) in the vicinity of the crystal (2, 2').

17. Resonator according to claim 15 and 16,
characterized in that
the free space (39) for vibration of the crystal (2, 2') is produced by the window (32, 33).

18. Resonator according to one or more of the claims 1 through 17,
characterized in that
at least one of the housing components, the bottom (6) or the lid (8), are made from a transparent material.

19. Resonator of claim 18,
characterized in that
at least one of the electrodes (3, 3', 4, 4') is post-processed using a laser after joining together the housing (5, 5') to achieve precise frequency matching.

20. Resonator of claim 18,
characterized in that
at least one of the electrodes (3, 3', 4, 4') is post-processed following joining together of the housing (5, 5') to achieve a precise frequency matching using a glow discharge.

21. Resonator according to one or more of the claims 1 through 20,
characterized in that
the electrodes (3, 3', 4, 4') are disposed on the crystal (2, 2').

22. Resonator according to one or more of the claims 1 through 20,
characterized in that
the electrodes (3, 3', 4, 4') are introduced on the lower side of the lid (8) and on the upper side of the bottom (6).

23. Resonator according to one or more of the claims 1 through 22,
characterized in that
a plurality of crystals (2, 2') are introduced into the housing (5').

24. Resonator according to claim 23,
characterized in that
a plurality of frame-shaped central portions (7, 7') are introduced between the bottom (6) and the lid (8).

25. Resonator according to claim 24,
characterized in that
intermediate bottoms (34) are disposed between the frame-shaped central portions (7, 7') having conducting surfaces (17, 28, 19, 20) for at least the production of the electrical connection between the at least one crystal (2') disposed thereabove and the circuit board (22).

26. Resonator according to claim 25,
characterized in that
the intermediate component (34) has a conducting layer (15, 15') on both the upper and the lower side to form the respective sealing surface (16), which is interrupted outside of the sealing surface (16) for potential separation (26, 26', 47).

27. Resonator according to one or more of the claims 23 through 26,
characterized in that
the crystals (2, 2') are connected to the circuit board (22) via separate connectors (35, 36, 37, 38).

28. Resonator according to one or more of the claims 23 through 26,
characterized in that
the individual resonators (1, 1') are connected in series.

29. Resonator according to one or more of the claims 23 through 26,
characterized in that
the individual resonators (1, 1') are connected in parallel.

30. Resonator according to one or more of the claims 1 through 29,
characterized in that
the free space (39) for vibration of the crystal (2, 2') is formed by tub-shaped recesses (40, 41) in the bottom (6) and the lid (8).

31. Resonator according to one or more of the claims 1 through 30,
characterized in that
the bottom (6) has connection surfaces (42) for soldering to the conducting tracks (23, 23', 23'', 23''') of the circuit board (22).

32. Resonator according to one or more of the claims 1 through 31,
characterized in that
all components (6, 7, 7', 8, 34) of the housing (5, 5') are made from the same quartz material as the crystal (2, 2').

33. Method for the manufacture of a resonator (1, 1') having at least one central portion (7, 7') comprising a crystal plate having two electrodes (3, 3', 4, 4') as well as a bottom (6) and a lid (8), having the following method steps:
a) the active crystal surface (2; 2') is freed in such a fashion that at least one connecting brace (28, 29, 30) remains to the frame-shaped central portion (7, 7') created thereby,
b) the active crystal surface (2, 2') is processed in such a fashion as to achieve the desired mechanical dimensioning,
c) the electrodes (3, 3') are introduced and optionally matched and connected to the conducting layers (9, 10, 11, 12,), and the at least one central portion (7, 7'), the bottom (6), and the lid (8) are joined together,
characterized in that,
prior to joining, at least one crystal plate (7, 7') is provided on both sides with conducting layers (9, 10, 11, 12), wherein the active crystal surface (2, 2') and at least one interruption (26, 26', 47), outside the sealing surfaces (13, 14, 15, 16) which effect a sealed housing region (25), remain and at least the bottom (6) is provided with at least two conducting surfaces (17, 18, 19, 20) which extend to the foot (21) of the bottom (6) in such a fashion that the bottom can be soldered to a cicuit board (22) and electrical connections can be established to the conducting layers (9, 10, 11, 12) of the at least one crystal plate (7, 7').

34. Method of claim 33,
characterized in that
the bottom (6) and the lid (8) are also provided with conducting layers (9', 10') at least in the vicinity of the sealing surfaces (13, 14) and the conducting layers (9, 10) of the crystal plate (7, 7') are connected to the conducting layers (9', 10') of the bottom (6) and the lid (8) during assembly.

35. Method according to claim 33 or 34,
characterized in that
at least one of the electrodes (3, 3', 4, 4') is post-processed through a transparent housing component (6, 8) using a laser.

36. Method according to claim 33 or 34,
characterized in that
at least one of the electrodes (3, 3', 4, 4') is post-processed through a transparent housing member (6, 8) using a glow discharge.

37. Method according to one of the claims 33 through 36,
characterized in that
the housing components (6, 8, 7, 7', 34) are sealed using vacuum underpressure and joined to each other using an additional joining technique.

## Revendications

1. Résonateur (1) avec au moins un cristal (2, 2'), au moins deux électrodes (3, 3', 4, 4') excitant ce cristal (2, 2') et un boîtier (5, 5') construit en sandwich avec un fond (6) sensiblement en forme de disque, au moins une partie médiane (7, 7') formant cadre qui entoure et porte de manière oscillante le cristal (2, 2') et un couvercle (8) sensiblement en forme de disque, ces parties de boîtier (6, 7, 7', 8) étant reliées entre elles par des surfaces d'étanchéité (13, 14, 15, 16) sous incorporation de couches conductrices (9 et 9', 10 et 10'; 11, 12), et les électrodes (3, 4; 3', 4') étant chacune reliées électriquement à une couche conductrice (9 et 9', 10 et 10'; 11, 12),
caractérisé
en ce que sur au moins un côté du boîtier (5, 5') au moins deux surfaces conductrices (17, 18, 19, 20) s'étendent en direction du pied (21) du fond (6) de telle sorte que celui-ci soit brasé sur une plaquette de circuit imprimé (22), les couches conductrices (9 et 9', 10 et 10'; 11 et 12) soient interrompues pour une séparation de potentiel à l'extérieur des surfaces d'étanchéité (13, 14, 15, 16) servant à obtenir une zone de boîtier (25) hermétique.

2. Résonateur selon la revendication 1,
caractérisé
en ce que les couches conductrices (9, 10) se trouvent sur au moins la partie médiane en forme de cadre (7), celles-ci étant reliées au fond (6) et au couvercle (8) pour la réalisation des surfaces d'étanchéité (11, 12, 13, 14).

3. Résonateur selon la revendication 2,
caractérisé
en ce que le couvercle (8) et la partie médiane (7) sont reliés par bonding entre eux.

4. Résonateur selon la revendication 2 ou 3,
caractérisé
en ce que le fond (6) et la partie médiane (7) sont reliés par bonding entre eux.

5. Résonateur selon la revendication 2 ou 3,
caractérisé
en ce que le fond (6) présente en haut une couche conductrice (10') qui est reliée à la couche conductrice correspondante (10) de la partie médiane (7), ces dernières coïncidant au moins dans la zone de la surface d'étanchéité (14).

6. Résonateur selon la revendication 2, 4 ou 5
caractérisé
en ce que 1 couvercle (8) présente en bas une couche conductrice (9') qui est reliée à la couche conductrice correspondante (9) de la partie médiane (7), ces dernières coïncidant au moins dans la zone de la surface d'étanchéité (13).

7. Résonateur selon l'une des revendications 1 à 6,
caractérisé
en ce que couches conductrices (9, 9'; 10, 10'; 11 ou 12) présentent à l'extérieur des surfaces d'étanchéité (13, 14, 15 ou 16) d'autres ruptures (43, 43').

8. Résonateur selon la revendication 7,
caractérisé
en ce que les autres ruptures (43, 43') servent au logement d'autres composants (27, 27').

9. Résonateur selon une ou plusieurs des revendications 1 à 8,
caractérisé
en ce que le cristal (2, 2') et la partie médiane formant cadre (7, 7') ne forment qu'une selle pièce, en ce que la surface active du résonateur du cristal (2, 2') est libérée en conservant au moins une barrette de connexion (28, 29, 30).

10. Résonateur selon la revendication 9,
caractérisé
en ce qu'il est prévu deux barrettes de connexion (29, 30) qui portent au moins chacune une ligne d'amenée d'électrode (31).

11. Résonateur selon une ou plusieurs des revendications 1 à 9,
caractérisé
en ce que la surface active de cristal (2, 2') est conçue pour obtenir une modification d'épaisseur.

12. Résonateur selon la revendication 11,
caractérisé
en ce que la modification d'épaisseur crée un espace libre (39) pour les oscillations du cristal (2, 2').

13. Résonateur selon une ou plusieurs des revendications 11 à 12,
caractérisé
en ce que la surface active du cristal (2, 2') est travaillée pour obtenir un moule.

14. Résonateur selon une ou plusieurs des revendications 11 à 13,
caractérisé
en ce que le travail de la surface active du cristal (2, 2') permet d'obtenir la fréquence désirée.

15. Résonateur selon une ou plusieurs revendications 6 à 14,
caractérisé
en ce que la couche conductrice (9') du couvercle (8) présente une fenêtre (33) dans la zone du cristal (2, 2').

16. Résonateur selon une ou plusieurs revendications 3 ou 5 à 13,
caractérisé
en ce que la couche conductrice (10') du fond (6) présente une fenêtre (32) dans la zone du cristal (2, 2').

17. Résonateur selon la revendication 15 ou 16,
caractérisé
en ce que l'espace libre (39) pour les oscillations du cristal (2, 2') est réalisé par les fenêtres (32, 33).

18. Résonateur selon une ou plusieurs revendications 1 à 17,
caractérisé en ce qu'au moins l'une des parties du coffret fond (6) ou couvercle (8) se compose d'un matériau transparent.

19. Résonateur selon la revendication 18,
caractérisé
en ce qu'au moins une des électrodes (3, 3', 4, 4') après l'assemblage du coffret (5, 5') est retravaillée pour obtenir une compensation exacte de fréquence au moyen d'un laser

20. Résonateur selon la revendication 18,
caractérisé
en ce qu'au moins une des électrodes (3, 3', 4, 4') après l'assemblage du coffret (5, 5') est retravaillée pour obtenir une compensation exacte de fréquence au moyen d'une décharge lumineuse.

21. Résonateur selon une ou plusieurs revendications 1 à 20,
caractérisé
en ce que les électrodes (3, 3', 4, 4') sont disposées sur le cristal (2, 2').

22. Résonateur selon une ou plusieurs revendications 1 à 20,
caractérisé
en ce que les électrodes (3, 3, 4, 4') sont placées sur la face inférieure du couvercle (8) et sur la face supérieure du fond (6).

23. Résonateur selon une ou plusieurs revendications 1 à 22,
caractérisé
en ce que plusieurs cristaux (2, 2') sont insérés dans le coffret (5').

24. Résonateur selon la revendication 23,
caractérisé en ce que plusieurs pièces médianes en forme de cadre (7, 7') sont insérées entre le fond (6) et le couvercle (8).

25. Résonateur selon la revendication 24,
caractérisé
en ce qu'entre les pièces médianes (7, 7') en forme de cadre se trouve des fonds intermédiaires qui présentent des surfaces conductrices (17, 28, 19, 20) au moins pour l'établissement de la liaison électrique entre au moins le cristal (2') se trouvant dessus et la plaquette imprimée (22).

26. Résonateur selon la revendication 25,
caractérisée
en ce que la partie intercalaire (34) présente en bas et en haut respectivement une couche conductrice (15, 15') formant la surface étanche respective (16) qui est interrompue (26, 26', 47) à l'extérieur de la surface étanche (16) pour la séparation du potentiel.

27. Résonateur selon une ou plusieurs revendications 23 à 26,
caractérisé
en ce que les cristaux (2, 2') sont reliés par des connexions séparées (35, 36, 37, 38) à la plaquette imprimée (22).

28. Résonateur selon une ou plusieurs revendications 23 à 26,
caractérisé
en ce que les différents résonateurs (1, 1') sont montés en série.

29. Résonateur selon une ou plusieurs revendications 23 à 26,
caractérisé
en ce que les différents résonateurs (1, 1') sont montés en parallèle.

30. Résonateur selon une ou plusieurs revendications 1 à 29,
caractérisé
en ce que l'espace libre (39) pour l'oscillation du cristal (2, 2') est formé par des évidements (40, 41) en forme de cuvette du fond (6) du couvercle (8).

31. Résonateur selon une ou plusieurs revendications 1 à 30,
caractérisé
en ce que le fond (6) présente des surfaces de connexion (42) pour le brasage avec les pistes conductrices (23, 23', 23'', 23"") de la plaquette imprimée (22).

32. Résonateur selon une ou plusieurs revendications 1 à 31,
caractérisé
en ce que tous les composants (6, 7, 7', 8, 34) du coffret (5, 5') se composent du même matériau de quartz que le cristal (2, 2').

33. Procédé pour la fabrication d'un résonateur (1, 1') avec au moins une partie médiane (7, 7') constituée d'une tranche de cristal avec deux électrodes (3, 3', 4, 4') ainsi qu'un fond (6) et un couvercle (8) comprenant les étapes suivantes de procédé :
a) la surface active de cristal (2; 2') est libérée de sorte qu'au moins une barrette de connexion (28, 29, 30) avec la partie médiane (7, 7') en forme de cadre en résultant est conservée.
b) la surface active de cristal (2, 2') est travaillée de telle sorte que la dimension mécanique souhaitée est obtenue,
c) les électrodes (3, 3') sont mises en place, le cas échéant travaillées pour la compensation et reliées aux couches conductrices (9, 10, 11, 12),
au moins une partie médiane (7, 7'), le fond (6) et le couvercle (8) étant assemblés,
caractérisé
en ce qu'avant l'assemblage au moins une tranche de cristal (7, 7') est munie des deux côtés de couches conductrices (9, 10, 11, 12), la surface active du cristal (2, 2') et au moins une interruption (26, 26', 47) à l'extérieur des surfaces étanches (13, 14, 15, 16) qui servent à obtenir une zone de coffret étanche (25), restent évidées et au moins le fond (6) est muni de deux surfaces conductrices (17, 18, 19, 20) qui s'étendent vers la base (21) du fond (6) de telle manière que le fond peut être soudé sur une plaquette imprimée (22) et des connexions électriques peuvent être établies avec les couches conductrices (9, 10, 11, 12) d'au moins une tranche de cristal (7, 7').

34. Procédé selon la revendication 33, caractérisé
en ce qu'également le fond (6) et le couvercle (8) sont munis au moins dans la zone des surfaces étanches (13, 14) de couches conductrices (9', 10') et en ce que lors de l'assemblage les couches conductrices (9, 10) de la tranche de cristal (7, 7') sont reliées aux couches conductrices (9', 10') du couvercle (8) et du fond (6).

35. Procédé selon la revendication 33 ou 34, caractérisé
en ce qu'au moyen d'un laser, au moins l'une des électrodes (3, 3', 4, 4') est retravaillée à travers une partie de coffret transparente (6, 8).

36. Procédé selon la revendication 33 ou 34, caractérisé
en ce qu'au moyen d'une décharge lumineuse, au moins l'une des électrodes (3, 3', 4, 4') est retravaillée à travers une partie de coffret transparente (6, 8).

37. Procédé selon l'une des revendications 33 à 36, caractérisé
en ce que
les parties de coffret (6, 8, 7, 7', 34) sont fermées par dépression sous vide et sont ensuite reliées entre elles par une autre technique de liaison.
